# EUROPEAN PATENT APPLICATION

(11) **EP 4 513 541 A2**
(43) Date of publication of application: **26.02.2025**
(21) Application number: 24184915.7
(22) Date of filing: 27.06.2024
(51) Int. Cl.: H01L 21/768, H01L 23/48, H01L 23/485, H10D 84/01

(54) **RECESSED VIA WITH CONDUCTIVE LINK TO ADJACENT CONTACT**

(30) Priority: 24.08.2023 US 202318455446
(71) Applicant: INTEL Corporation, Santa Clara, CA 95054 (US)
(72) Inventor: GULER, Leonard P., Hillsboro, OR 97124 (US); TEWELDEBRHAN, Desalegne B., Sherwood, OR 97140 (US); LIU, Shengsi, Portland, OR 97229 (US); ACHARYA, Saurabh, Beaverton, OR 97007 (US); RADOSAVLJEVIC, Marko, Portland, OR 97229 (US); SCHENKER, Richard, Portland, OR 97229 (US)
(74) Representative: 2SPL Patentanwälte PartG mbB

(57) **Abstract**

Techniques to form semiconductor device conductive interconnections. In an example, an integrated circuit includes a recessed via and a conductive bridge between a top surface of the recessed via and an adjacent source or drain contact. A transistor device includes a semiconductor material extending from a source or drain region, a gate structure over the semiconductor material, and a contact on the source or drain region. Adjacent to the source or drain region, a deep via structure extends in a vertical direction through an entire thickness of the gate structure. The via structure includes a conductive via that is recessed below a top surface of the conductive contact. A conductive bridge extends between the contact and the conductive via such that the conductive bridge contacts a portion of the contact and at least a portion of a top surface of the conductive via.

## Description

### FIELD OF THE DISCLOSURE

The present disclosure relates to integrated circuits, and more particularly, to contacts for semiconductor elements.

### BACKGROUND

As integrated circuits continue to scale downward in size, a number of challenges arise. For instance, reducing the size of memory and logic cells is becoming increasingly more difficult, as is reducing device spacing at the device layer. As transistors are packed more densely, the formation of certain interconnect structures can be challenging given the limited spacing and number of tracks used for a given interconnect layer. Furthermore, the closely packed elements can increase parasitic effects that undermine transistor performance. Accordingly, there remain a number of non-trivial challenges with respect to forming semiconductor devices.

### BRIEF DESCRIPTION OF THE DRAWINGS

Figures 1A and 1B are cross-sectional views of some semiconductor devices that illustrate a recessed via connected to an adjacent source or drain contact, in accordance with an embodiment of the present disclosure.
Figure 1C is a plan view of the integrated circuit of Figures 1A and 1B, in accordance with an embodiment of the present disclosure.
Figures 2A and 2B are cross-sectional views that illustrate a stage in an example process for forming semiconductor devices that have a recessed via connected to an adjacent source or drain contact, in accordance with some embodiments of the present disclosure.
Figures 3A and 3B are cross-sectional views that illustrate another stage in the example process for forming semiconductor devices that have a recessed via connected to an adjacent source or drain contact, in accordance with some embodiments of the present disclosure.
Figures 4A and 4B are cross-sectional views that illustrate another stage in the example process for forming semiconductor devices that have a recessed via connected to an adjacent source or drain contact, in accordance with some embodiments of the present disclosure.
Figures 5A and 5B are cross-sectional views that illustrate another stage in the example process for forming semiconductor devices that have a recessed via connected to an adjacent source or drain contact, in accordance with some embodiments of the present disclosure.
Figures 6A and 6B are cross-sectional views that illustrate another stage in the example process for forming semiconductor devices that have a recessed via connected to an adjacent source or drain contact, in accordance with some embodiments of the present disclosure.
Figures 7A and 7B are cross-sectional views that illustrate another stage in the example process for forming semiconductor devices that have a recessed via connected to an adjacent source or drain contact, in accordance with some embodiments of the present disclosure.
Figures 8A and 8B are cross-sectional views that illustrate another stage in the example process for forming semiconductor devices that have a recessed via connected to an adjacent source or drain contact, in accordance with some embodiments of the present disclosure.
Figures 9A and 9B are cross-sectional views that illustrate another stage in the example process for forming semiconductor devices that have a recessed via connected to an adjacent source or drain contact, in accordance with some embodiments of the present disclosure.
Figures 10A and 10B are cross-sectional views that illustrate another stage in the example process for forming semiconductor devices that have a recessed via connected to an adjacent source or drain contact, in accordance with some embodiments of the present disclosure.
Figures 11A and 11B are cross-sectional views that illustrate another stage in the example process for forming semiconductor devices that have a recessed via connected to an adjacent source or drain contact, in accordance with some embodiments of the present disclosure.
Figures 12A and 12B are cross-sectional views that illustrate another stage in the example process for forming semiconductor devices that have a recessed via connected to an adjacent source or drain contact, in accordance with some embodiments of the present disclosure.
Figures 13A and 13B are cross-sectional views that illustrate another stage in the example process for forming semiconductor devices that have a recessed via connected to an adjacent source or drain contact, in accordance with some embodiments of the present disclosure.
Figure 14 illustrates a cross-sectional view of a chip package containing one or more semiconductor dies, in accordance with some embodiments of the present disclosure.
Figure 15 is a flowchart of a fabrication process for semiconductor devices having a recessed via connected to an adjacent source or drain contact, in accordance with an embodiment of the present disclosure.
Figure 16 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form conductive contacts of semiconductor devices. The techniques can be used, for instance, to interconnect nodes or terminals of the same semiconductor device or different semiconductor devices. In an example, an integrated circuit includes a recessed via and a conductive bridge between a top surface of the recessed via and an adjacent source or drain contact. The techniques can be used in any number of integrated circuit applications and are particularly useful with respect to device layer transistors, such as finFETs or gate-all-around transistors (e.g., ribbonFETs and nanowire FETs). In an example, a semiconductor device includes a gate structure around or otherwise on a semiconductor region (or channel region). The semiconductor region can be, for example, a fin of semiconductor material that extends from a source or drain region, or one or more nanowires or nanoribbons or nanosheets of semiconductor material that extend from the source or drain region (more generally, a diffusion region). A conductive contact is formed over the source or drain region. Adj acent to the semiconductor region, a via structure extends in a vertical direction through an entire thickness of the gate structure. The via structure also extends in the same direction as the channel region such that the via structure extends adjacent to the source or drain region. The via structure includes a conductive core (or simply referred to as a via) that is recessed below a top surface of the conductive contact. A conductive bridge extends between the contact and the conductive via such that the conductive bridge contacts a portion of the contact and at least a portion of a top surface of the conductive via. Numerous variations and embodiments will be apparent in light of this disclosure.

### General Overview

As previously noted above, there remain a number of non-trivial challenges with respect to integrated circuit fabrication. In more detail, as devices become smaller and more densely packed, many structures become more challenging to fabricate as critical dimensions (CD) of the structures push the limits of current fabrication technology. Interconnects can be particularly challenging with the number of connections to be made and a limited footprint. Reducing the number of metal connections made in the interconnect region above (or below) a given device layer can create more space for forming other metal routing layers and vias, which can reduce the overall complexity of the device. Additionally, the densely packed devices of a given device layer have numerous closely spaced conductive elements that may generate parasitic capacitance, which can degrade the transistor performance. Removing portions of the conductive elements within the device layer or local interconnect while maintaining their electrical purpose is thus beneficial for reducing the parasitic capacitance.

Thus, and in accordance with an embodiment of the present disclosure, a conductive via adjacent to a contact over a source or drain region is recessed below the top surface of the contact and a conductive bridge is formed in the device layer to connect the contact to the via. According to some embodiments, the conductive via may be recessed until its top surface is below a top surface of the adjacent source or drain region. The via may extend in a first direction along one side of the source or drain region and also along one side of a semiconductor region (channel region) extending in the first direction from the source or drain region. The via may also extend vertically through an entire thickness of a gate structure that extends in a second direction across the semiconductor region. Accordingly, a top surface of the via may also be recessed below a top surface of the gate structure as the via passes through the gate structure in the first direction.

According to some embodiments, a conductive bridge contacts both a sidewall portion of the conductive contact and at least a portion of the top surface of the conductive via. In this way, the conductive bridge is formed within the device layer (e.g., beneath any interconnect layers) and eliminates the need for a metal layer connecting the contact to the via in the interconnect region. The conductive bridge may include the same conductive material as the contact and/or via. In some such cases, no seams may be visible between the conductive bridge and where it contacts both the contact and the via, although depositions of the same material at different times may result in a visible seam between the bridge, contact, and/or via. In some other examples, the conductive bridge includes a different conductive material than the contact and/or via. Example conductive materials for any of the contact, conductive bridge, or via include cobalt, tungsten, molybdenum, or ruthenium, although other conductive materials suitable to a given application may be used as well.

In some embodiments, a dielectric wall extends between the source or drain region and an adjacent source or drain region on an opposite side of the source or drain region from the via. The dielectric wall may also extend between corresponding gate structures of the adjacent devices. The conductive contact may extend through a portion of the dielectric wall to be arranged over the adjacent source or drain region, according to some embodiments. In some examples, portions of other dielectric walls can be removed such that the contact also extends between adjacent source or drain regions while contacting the adjacent source or drain regions.

According to an embodiment, an integrated circuit includes a semiconductor region extending in a first direction from a source or drain region, a gate electrode extending in a second direction over the semiconductor region, a dielectric layer beneath the gate electrode, a contact on a top surface of the source or drain region, a conductive via extending in the first direction adjacent to the semiconductor region, extending in the first direction adjacent to the source or drain region, and extending in a third direction through a portion of the gate electrode and through an entire thickness of the dielectric layer, and a conductive bridge between the contact and the conductive via. A top surface of the conductive via is below a top surface of the contact, and the conductive bridge extends from a sidewall of the contact and is on at least a portion of the top surface of the conductive via.

According to another embodiment, an integrated circuit includes a semiconductor region extending in a first direction from a source or drain region, a gate electrode extending in a second direction over the semiconductor region, a dielectric layer beneath the gate electrode, a conductive via extending in the first direction adjacent to the semiconductor region, extending in the first direction adjacent to the source or drain region, and extending in a third direction through a portion of the gate electrode and through an entire thickness of the dielectric layer, and a conductive contact on a top surface of the source or drain region. A top surface of the conductive via is below a top surface of the gate electrode, and the conductive contact extends in the second direction to contact at least a portion of the top surface of the conductive via.

According to another embodiment, a method of forming an integrated circuit includes forming a fin comprising semiconductor material, the fin extending above a substrate and extending in a first direction; forming a gate electrode extending over the fin in a second direction different from the first direction; forming a source or drain region at an end of the fin; forming a contact over the source or drain region; forming a recess through the gate electrode adjacent to the fin, the recess extending in the first direction through the gate electrode and adjacent to the source or drain region; forming a dielectric material within the recess; forming a conductive via within the recess, the conductive via extending in the first direction, such that the dielectric material is between the conductive via and the gate electrode and the dielectric material is between the conductive via and the contact; recessing the conductive via such that a top surface of the conductive via is below a top surface of the contact; forming a dielectric cap over the top surface of the recessed conductive via; recessing a portion of the dielectric material between the dielectric cap and the contact and recessing at least a portion of the dielectric cap, such that at least a portion of the top surface of the conductive via is exposed; and forming a conductive bridge over the at least a portion of the top surface of the conductive via, the conductive bridge abutting the contact.

The techniques can be used with any type of non-planar transistors, including finFETs (sometimes called tri-gate transistors), nanowire and nanoribbon transistors (sometimes called gate-all-around transistors), or forksheet transistors, to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a recessed via having a conductive bridge between a portion of a top surface of the recessed via and an adjacent source or drain contact. Seams may or may not be visible between each of the contact, conductive bridge, and via depending on the conductive materials used and process flow. The conductive bridge between the contact and via may be observed within the device layer below any interconnect layers.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

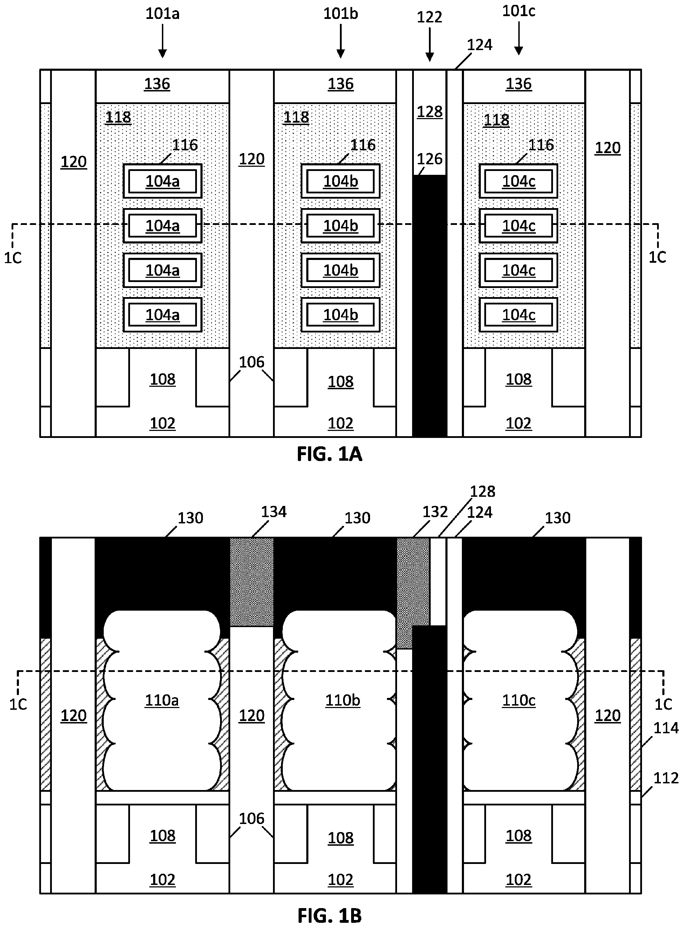

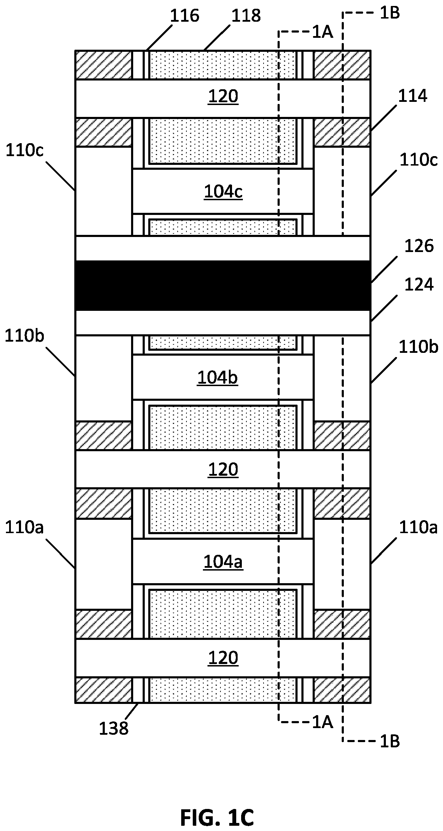

Figure 1A is a cross-sectional view taken across the gate trench of three example semiconductor devices, a first semiconductor device 101a, a second semiconductor device 101b, and a third semiconductor device 101c according to an embodiment of the present disclosure. Figure 1B is another cross-sectional view taken across the source/drain trench or diffusion region and contact trench adjacent to the gate trench either into or out of the page of Figure 1A. Figure 1C is a top-down cross-section view of the adjacent semiconductor devices 101a/101b/101c taken across the dashed line 1C-1C depicted in both Figure 1A and Figure 1B. Figure 1A illustrates the cross-section taken across the dashed line 1A-1A depicted in Figure 1C, and Figure 1B illustrates the cross-section taken across the dashed line 1B-1B depicted in Figure 1C. It should be noted that some of the material layers (such as dielectric cap layer 136) are not visible in the top-down view of Figure 1C, given the location of the depicted cross-section.

Each of semiconductor devices 101a/101b/101c may be, for example, non-planar metal oxide semiconductor (MOS) transistors, such as tri-gate (e.g., finFET) or gate-all-around (GAA) transistors, although other transistor topologies and types could also benefit from the techniques provided herein. The illustrated example embodiments use the GAA structure. The various illustrated semiconductor devices represent a portion of an integrated circuit that may contain any number of similar semiconductor devices.

As can be seen, semiconductor devices 101a/101b/101c are formed on a substrate 102. Any number of semiconductor devices can be formed on substrate 102, but three are illustrated here as an example. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, a lower portion of (or all of) substrate 102 is removed and replaced with one or more backside interconnect layers to form backside signal and power routing, during a backside process.

Each of semiconductor devices 101a/101b/101c includes one or more corresponding nanoribbons 104a/104b/104c, respectively, that extend parallel to one another along a direction between corresponding source or drain regions, as seen more clearly in Figure 1C (e.g., a first direction into and out of the page in the cross-section view of Figure 1A). Accordingly, nanoribbons 104a extend between source or drain regions 110a, nanoribbons 104b extend between source or drain regions 110b, and nanoribbons 104c extend between source or drain regions 110c. Nanoribbons 104a/104b/104c are one example of semiconductor regions or semiconductor bodies that extend between source or drain regions. The term nanoribbon may also encompass other similar shapes such as nanowires or nanosheets. The semiconductor material of nanoribbons 104a/104b/104c may be formed from substrate 102. In some embodiments, semiconductor devices 101a/101b/101c may each include semiconductor regions in the shape of fins that can be, for example, native to substrate 102 (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitate forming of the illustrated nanoribbons 104a/104b/104c during a gate forming process where one type of the alternating layers is selectively etched away so as to liberate the other type of alternating layers within the channel region, so that a gate-all-around (GAA) process can then be carried out. Again, the alternating layers can be blanket deposited and then etched into fins or deposited into fin-shaped trenches.

As can further be seen, adjacent semiconductor devices are separated by a dielectric fill 106. Dielectric fill 106 provides shallow trench isolation (STI) between any adjacent semiconductor devices. Dielectric fill 106 can be any suitable dielectric material, such as silicon dioxide, aluminum oxide, or silicon oxycarbonitride.

Semiconductor devices 101a/101b/101c each include a subfin region 108. According to some embodiments, subfin region 108 comprises the same semiconductor material as substrate 102 and is adjacent to dielectric fill 106. According to some embodiments, nanoribbons 104a/104b/104c (or other semiconductor bodies) extend between source or drain regions 110a/110b/110c in the first direction to provide an active region (sometimes called channel region) for a transistor (e.g., the semiconductor region beneath the gate). It should be understood that the source or drain regions 110a/110b/110c illustrated in the cross-section of Figure 1B are only along one side of nanoribbons 104a/104b/104c (e.g., out of the page of FIG. 1A) and that similar source or drain regions may be present along the opposite side of nanoribbons 104a/104b/104c, as shown in Figure 1C.

According to some embodiments, the source or drain regions are epitaxial regions that are provided using an etch-and-replace process. In other embodiments the source or drain regions could be, for example, implantation-doped native portions of the semiconductor fins or substrate. Any semiconductor materials suitable for source and drain regions can be used (e.g., group IV and group III-V semiconductor materials). The composition and doping of the source or drain regions may be the same or different, depending on the polarity of the transistors. In an example, for instance, one transistor is a p-type MOS (PMOS) transistor, and the other transistor is an n-type MOS (NMOS) transistor. As such, source or drain region 110a may have a different dopant type (n or p) compared to source or drain region 110b. Any number of source or drain configurations and materials can be used.

According to some embodiments, a lower dielectric layer 112 exists beneath source or drain regions 110a/110b/110c. Lower dielectric layer 112 can include any suitable dielectric material, such as silicon dioxide or silicon nitride or silicon oxynitride and may be provided to isolate source or drain regions 110a/110b/110c from subfin regions 108. According to some embodiments, another dielectric fill 114 is provided around and over portions of source or drain regions 110a/110b/110c along the source/drain trench after epitaxial formation of the source/drain regions is complete. Accordingly, each source or drain region may be isolated from any adjacent source or drain regions by dielectric fill 114. Dielectric fill 114 may be any suitable dielectric material, although in some embodiments, dielectric fill 114 includes the same dielectric material as dielectric fill 106 or lower dielectric layer 112. In one example, each of dielectric fill 114, lower dielectric layer 112, and dielectric fill 106 includes silicon dioxide.

According to some embodiments, a gate structure extends over nanoribbons 104a/104b/104c of semiconductor devices 101a/101b/101c along a second direction across the page of Figure 1A. The gate structure includes a gate dielectric 116 and a gate electrode 118. Gate dielectric 116 represents any number of dielectric layers present between nanoribbons 104a/104b/104c and gate electrode 118. Gate dielectric 116 may also be present on the surfaces of other structures within the gate trench, such as on subfin regions 108. Gate dielectric 116 may include any suitable gate dielectric material(s). In some embodiments, gate dielectric 116 includes a layer of native oxide material (e.g., silicon dioxide) on the nanoribbons or other semiconductor regions making up the channel region of the devices, and a layer of high-k dielectric material (e.g., hafnium oxide) on the native oxide.

Gate electrode 118 may represent any number of conductive layers, such as any metal, metal alloy, or doped polysilicon layers. In some embodiments, gate electrode 118 includes one or more workfunction metals around nanoribbons 104a/104b/104c. In some embodiments, one of semiconductor devices 101a/101b/101c is a p-channel device that includes a workfunction metal having titanium around its nanoribbons and another semiconductor device is an n-channel device that includes a workfunction metal having tungsten around its nanoribbons. Gate electrode 118 may also include a fill metal or other conductive material around the workfunction metals to provide the whole gate electrode structure.

According to some embodiments, dielectric walls 120 are present between some adjacent semiconductor devices. In the illustrated example a first gate structure is present over nanoribbons 104a and a second gate structure is present over nanoribbons 104b with dielectric wall 120 separating the two gate structures. Dielectric walls 120 extend along the first direction (e.g., into and out of the page) across the gate trench and further along the source/drain trench to isolate adjacent source or drain regions from each other. In the illustrated example, a given dielectric wall 120 extends between source or drain region 110a and source or drain region 110b. Dielectric walls 120 may continue to extend in the first direction to separate any number of other devices from one another within the integrated circuit. Dielectric walls 120 extend through at least an entire thickness of the gate structures. In some examples, dielectric walls 120 also extend through an entire thickness of dielectric fill 106. Dielectric walls 120 may be formed from a sufficiently insulating material, such as a dielectric material. Example materials for dielectric walls 120 include silicon nitride, silicon dioxide, or silicon oxynitride. According to some embodiments, dielectric walls 120 each has a width between about 10 nm and about 15 nm.

According to some embodiments, one or more via structures 122 extend between some adjacent semiconductor devices in a similar fashion to dielectric walls 120. In the illustrated example, via structure 122 extends between the second gate structure over nanoribbons 104b and a third gate structure over nanoribbons 104c. Like dielectric walls 120, via structure 122 extends along the first direction (e.g., into and out of the page) across the gate trench and further along the source/drain trench to isolate adjacent source or drain regions from each other. In the illustrated example, via structure 122 extends between source or drain region 110b and source or drain region 110c. Via structure 122 extends through at least an entire thickness of the gate structures and also through an entire thickness of dielectric fill 106.

According to some embodiments, via structure 122 includes a dielectric liner 124 along sidewalls of via structure 122 and a conductive via 126 (e.g., the conductive core of the via structure). Dielectric liner 124 may include any suitable dielectric material, such as silicon nitride, silicon dioxide, silicon oxycarbide, or silicon oxycarbonitride, or a low-k version of any of these, to name a few examples. A low-k dielectric material generally refers to materials with a dielectric constant lower than that of silicon dioxide, such as porous silicon dioxide, or lower than 3.9. Dielectric liner 124 may represent any number of dielectric layers, such as a first dielectric layer directly on gate electrode 118 that includes a high-k dielectric material (e.g., dielectric constant of silicon nitride or higher) and a second dielectric layer on the first dielectric layer, where the second dielectric layer includes a low-k dielectric material. Conductive via 126 may include any suitable metal material such as tungsten, cobalt, ruthenium, or molybdenum, to name a few examples. According to some embodiments, via structure 122 also includes a dielectric cap 128 on a top surface of conductive via 126. Dielectric cap 128 may include any suitable dielectric material and may be the same dielectric material as dielectric liner 124.

According to some embodiments, conductive contacts 130 are formed on source or drain regions 110a - 110c, respectively. According to some embodiments, each conductive contact 130 includes a conductive fill and a conductive liner along outside edges of the conductive fill. The conductive fill may be any suitably conductive material such as tungsten. Other conductive materials may include ruthenium, cobalt, molybdenum, or any alloys thereof. The conductive liner may be, for instance, a barrier layer and/or resistance-reducing layer that includes titanium or tantalum (e.g., titanium nitride or tantalum nitride), silicide, or some other suitable liner layer.

According to some embodiments, a top surface of conductive via 126 is recessed below a top surface of contacts 130. Conductive via 126 may be recessed along its entire length such that the top surface of conductive via 126 is also recessed below a top surface of gate electrode 118 as shown in both Figures 1A and 1B. In some examples, the top surface of conductive via 126 is also below a top surface of either adjacent source or drain region 110b/110c. Dielectric cap 128 may be formed within the cavity that is left behind after recessing conductive via 126 between dielectric liner 124.

According to some embodiments, a conductive bridge 132 extends between conductive via 126 and an adjacent contact 130. Conductive bridge 132 may contact at least a portion of a sidewall of contact 130 and at least a portion of the top surface of conductive via 126. In some embodiments, a top surface of conductive bridge 132 is substantially coplanar (e.g., within 2 nm) with a top surface of contact 130. Conductive bridge 132 may include any suitable conductive material such as tungsten, cobalt, ruthenium, or molybdenum, to name a few examples. Conductive bridge 132 may include the same conductive material as contact 130 and/or conductive via 126. In examples where each of contact 130, conductive bridge 132, and conductive via 126 includes the same conductive material, no seams may be visible between each of the conductive elements. According to some embodiments, conductive bridge 132 may extend some distance below the top surface of conductive via 126.

According to some embodiments, a portion of a dielectric wall 120 between adjacent contacts 130 may be removed and replaced with a conductive plug 134. Conductive plug 134 may extend in the second direction to contact the sides of both adjacent contacts. Conductive plug 134 may include any suitable conductive material such as tungsten, cobalt, ruthenium, or molybdenum, to name a few examples. Conductive plug 134 may include the same conductive material as conductive bridge 132 and may be formed at substantially the same time as conductive bridge 132 (e.g., during the same metal deposition process).

According to some embodiments, a dielectric cap layer 136 runs along a top surface of the gate structures in the gate trench. Accordingly, dielectric cap layer 136 may run along the second direction on the top surface of gate electrode 118 and be interrupted by any dielectric walls 120 and via structures 122. Dielectric cap layer 136 may include the same dielectric material as dielectric walls 120, in some examples.

Figure 1C illustrates the plan view of the integrated circuit showing how nanoribbons 104a/104b/104c extend between corresponding source or drain regions 110a/110b/110c. According to some embodiments, spacer structures 138 extend along the sides of the gate trench and isolate the gate trench from the source/drain trench (including epi regions and their respective contacts). Spacer structures 138 may include any suitable dielectric material, such as silicon nitride. The nanoribbons 104a/104b/104c (or other channel body) extend through spacer structures 138 to contact respective source or drain regions.

### Fabrication Methodology

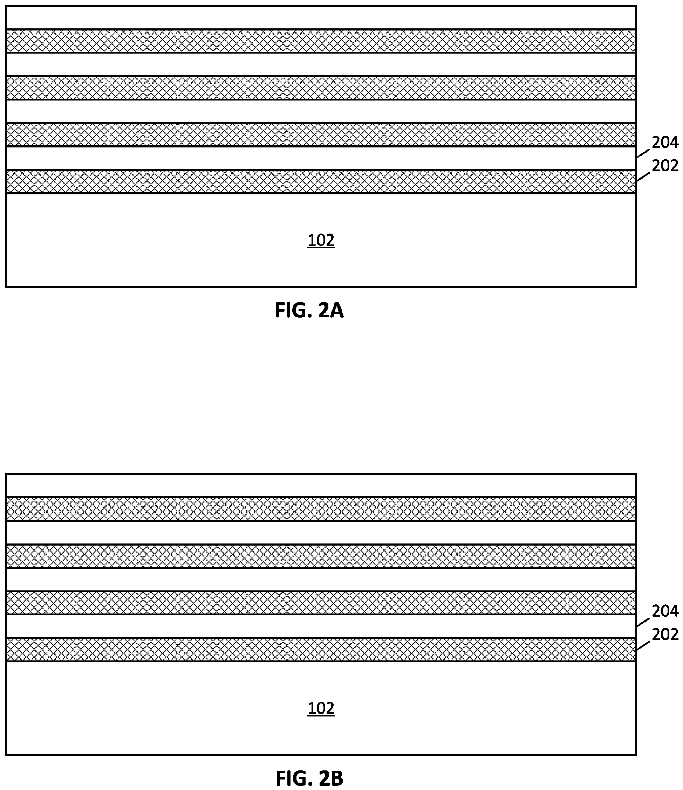

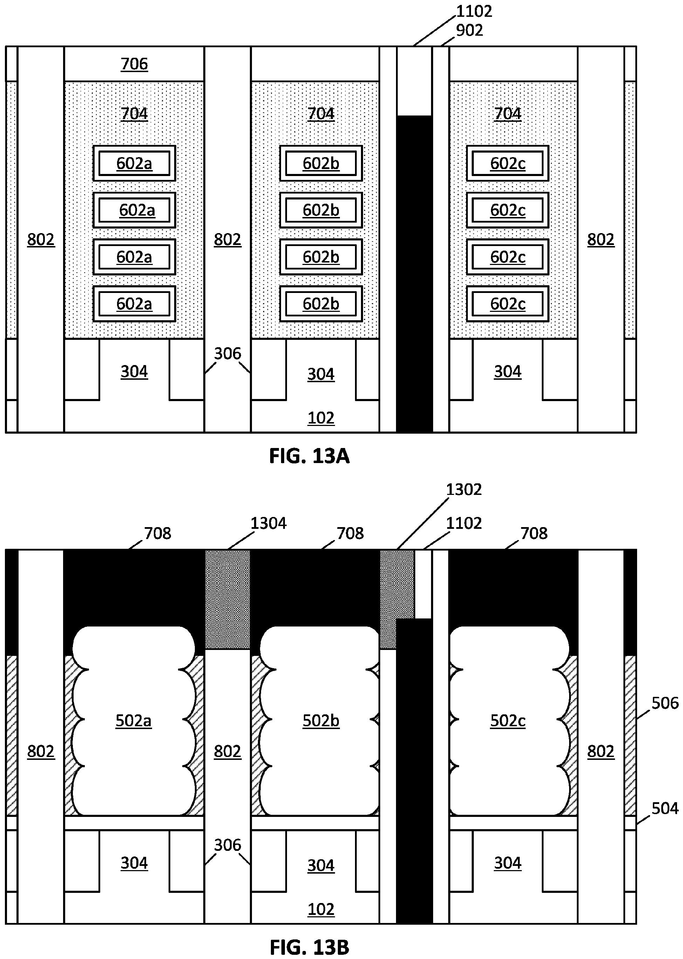

Figures 2A - 13A and 2B - 13B are cross-sectional views that collectively illustrate a first example process for forming an integrated circuit configured with a recessed via connected to an adjacent source or drain contact, in accordance with an embodiment of the present disclosure. Figures 2A - 13A represent cross-sectional views taken across a gate trench of the integrated circuit, while figures 2B - 13B represent cross-sectional views taken across the source/drain trench adjacent to the gate trench along the same direction. Each figure shows an example structure that results from the process flow up to that point in time, so the depicted structure evolves as the process flow continues, culminating in the structure shown in Figures 13A and 13B, which is similar to the structure shown in Figures 1A and 1B, respectively. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated. Figures sharing the same number (e.g., Figures 2A and 2B) illustrate different views of the structure at the same point in time during the process flow. Although the fabrication of a single via structure is illustrated in the aforementioned figures, it should be understood that any number of similar via structures can be fabricated across the integrated circuit using the same processes discussed herein.

Figures 2A and 2B illustrate parallel cross-sectional views taken through a stack of alternating semiconductor layers on a semiconductor substrate 102. Figure 2A is taken across a portion of the stack that will eventually become a gate trench while Figure 2B is taken across a portion of the stack that will eventually become a source/drain trench adjacent and parallel to the gate trench. Alternating material layers may be deposited over substrate 102 including sacrificial layers 202 alternating with semiconductor layers 204. The alternating layers are used to form GAA transistor structures. Any number of alternating semiconductor layers 204 and sacrificial layers 202 may be deposited over substrate 102.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204. In some examples, semiconductor layers 204 may be doped with either n-type dopants (to produce a p-channel transistor) or p-type dopants (to produce an n-channel transistor).

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm), and the thickness of each of semiconductor layers 204 may be about the same as the thickness of each sacrificial layer 202 (e.g., about 5-20 nm). Each of sacrificial layers 202 and semiconductor layers 204 may be deposited using any known or proprietary material deposition technique, such as chemical vapor deposition (CVD), plasma-enhanced chemical vapor deposition (PECVD), physical vapor deposition (PVD), or atomic layer deposition (ALD).

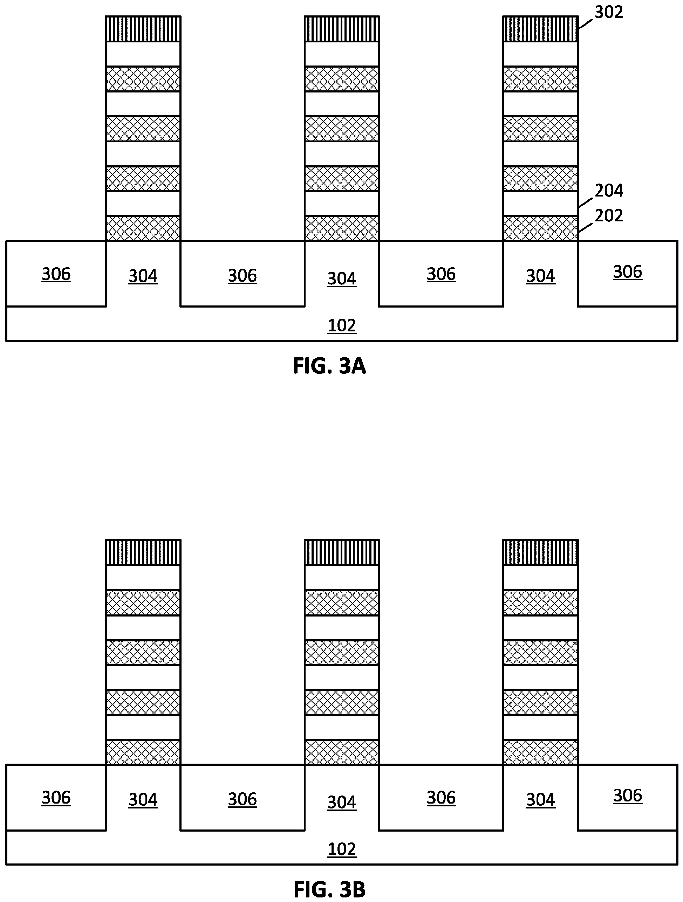

Figures 3A and 3B depict the cross-section views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows to form corresponding rows of fins from the alternating layer stack of sacrificial layers 202 and semiconductor layers 204. The rows of fins extend lengthwise in a first direction (e.g., into and out of the page of each cross-section view).

According to some embodiments, an anisotropic etching process through the layer stack continues into at least a portion of substrate 102, where the unetched portions of substrate 102 beneath the fins form subfin regions 304. The etched portions of substrate 102 may be filled with a dielectric fill 306 that acts as shallow trench isolation (STI) between adjacent fins. Dielectric fill 306 may be any suitable dielectric material such as silicon dioxide, and may be recessed to a desired depth as shown (in this example case, down to around the upper surface of subfin regions 304), so as to define the active portion of the fins that will be covered by a gate structure. In some embodiments, dielectric fill 306 is recessed below the top surface of subfin regions 304.

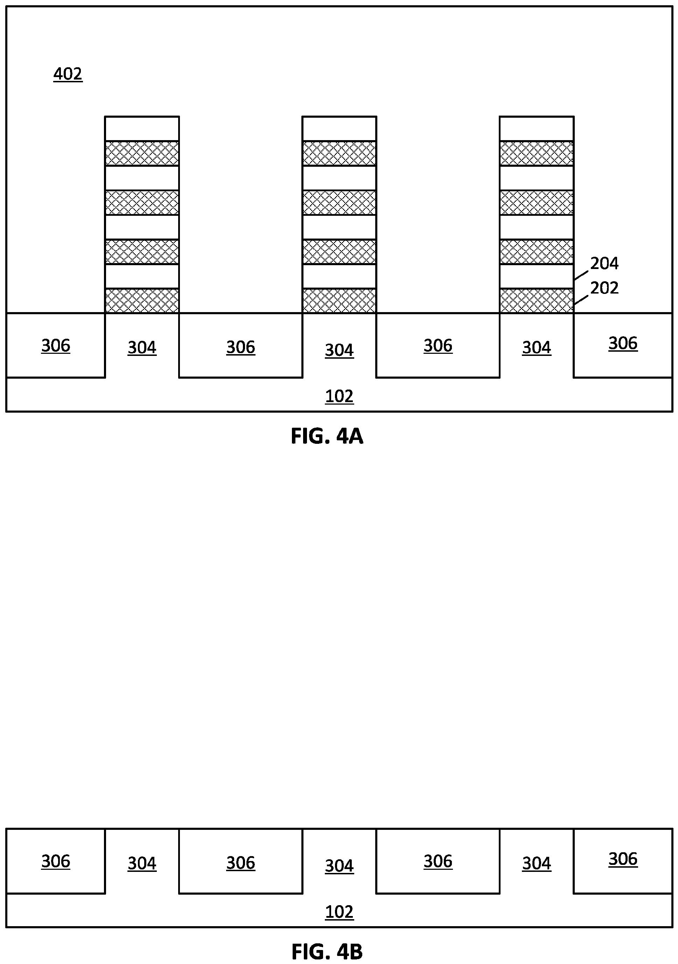

Figures 4A and 4B depict the cross-section views of the structure shown in Figures 3A and 3B, respectively, following the formation of a sacrificial gate 402 extending across the fins in a second direction different from the first direction, according to some embodiments. Sacrificial gate 402 may extend across the fins in a second direction that is orthogonal to the first direction. According to some embodiments, the sacrificial gate material is formed in parallel strips across the integrated circuit and removed in all areas not protected by a gate masking layer. Sacrificial gate 402 may be any suitable material that can be selectively removed without damaging the semiconductor material of the fins. In some examples, sacrificial gate 402 includes polysilicon.

As seen in the cross-section views, sacrificial gate 402 extends across the fins along the gate trench cross-section of Figure 4A but is not present along the source/drain trench cross-section of Figure 4B. Accordingly, sacrificial gate 402 (along with any gate spacers formed on the sidewalls of sacrificial gate 402) protect the underlying portions of the fins while the exposed portions of the fins are etched away as seen in Figure 4B. According to some embodiments, both semiconductor layers 204 and sacrificial layers 202 are etched at substantially the same rate using an anisotropic RIE process. As observed in Figure 4B, the fins are completely removed above subfin regions 304. In some embodiments, the RIE process may also etch into subfin regions 304 thus recessing subfin regions 304 beneath a top surface of dielectric fill 306. In some embodiments, inner gate spacers can be formed after the source/drain trenches are etched and before any formation of source or drain regions. For instance, a selective etch can be used to laterally recess sacrificial layers 202, and that recess can then be filled with inner gate spacer material (e.g., silicon nitride or silicon oxynitride). Any excess gate spacer material can be removed with directional etching.

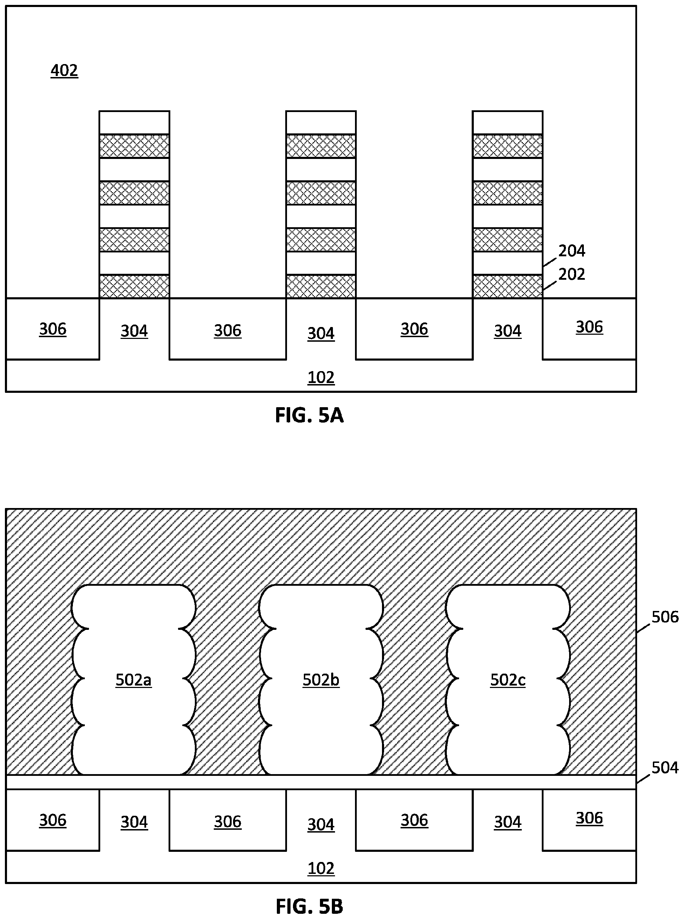

Figures 5A and 5B depict the cross-section views of the structure shown in Figures 4A and 4B, respectively, following the formation of source or drain regions 502a/502b/502c at the ends of each of the fins (extending into and out of the page in Figure 5A), according to some embodiments. Source or drain regions 502a/502b/502c may be epitaxially grown from the exposed ends of semiconductor layers 204, such that the material grows together or otherwise merges towards the middle of the trenches between fins, according to some embodiments. Note that epitaxial growth on one semiconductor layer 204 can fully or partially merge with epitaxial growth on one or more other semiconductor layers 204 in the same vertical stack. The degree of any such merging can vary from one embodiment to the next. In the example of a PMOS device, a given source or drain region may be a semiconductor material (e.g., group IV or group III-V semiconductor materials) having a higher dopant concentration of p-type dopants compared to n-type dopants. In the example of an NMOS device, a given source or drain region may be a semiconductor material (e.g., group IV or group III-V semiconductor materials) having a higher dopant concentration of n-type dopants compared to p-type dopants. According to some embodiments, source or drain regions 502a/502b/502c grown from different semiconductor devices may be aligned along the source/drain trench in the second direction as shown in Figure 5B.

According to some embodiments, a bottom dielectric layer 504 may be deposited prior to the formation of source or drain regions 502a/502b/502c. Bottom dielectric layer 504 may be any suitable dielectric material, such as silicon dioxide, silicon nitride, or silicon oxynitride. Bottom dielectric layer 504 may be included to provide isolation between source or drain regions 502a/502b/502c and subfin regions 304.

According to some embodiments, another dielectric fill 506 is provided along the source/drain trench. Dielectric fill 506 may extend between adjacent ones of the source or drain regions 502a/502b/502c along the second direction and also may extend up and over each of the source or drain regions 502a/502b/502c, according to some embodiments. Accordingly, each source or drain region may be isolated from any adjacent source or drain regions by dielectric fill 506. Dielectric fill 506 may be any suitable dielectric material, although in some embodiments, dielectric fill 506 includes the same dielectric material as dielectric fill 306 or bottom dielectric layer 504. In one example, each of dielectric fill 506, bottom dielectric layer 504, and dielectric fill 306 includes silicon dioxide. Dielectric fill 506 may not be present between certain adjacent source or drain regions in situations where the adjacent source or drain regions are desired to be electrically coupled together. According to some embodiments, a top surface of dielectric fill 506 may be polished using, for example, chemical mechanical polishing (CMP). The top surface of dielectric fill 506 may be polished until it is substantially coplanar with a top surface of sacrificial gate 402.

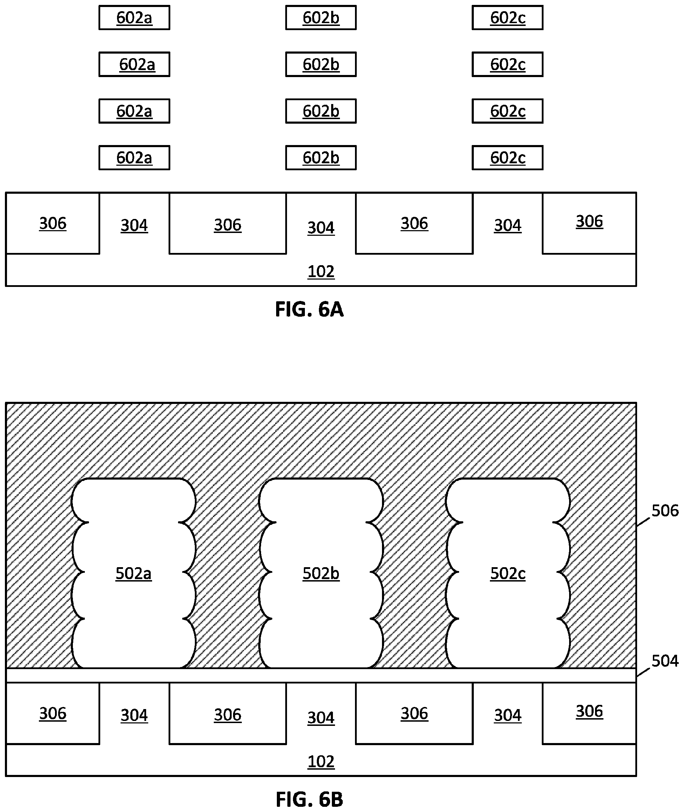

Figures 6A and 6B depict the cross-section views of the structure shown in Figures 5A and 5B, respectively, following the formation of nanoribbons 602a/602b/602c from semiconductor layers 204, according to some embodiments. Depending on the dimensions of the structures, nanoribbons 602a/602b/602c may also be considered nanowires or nanosheets. Sacrificial gate 402 may be removed using any wet or dry isotropic process thus exposing the alternating layer stack of the fins within the trenches left behind after the removal of sacrificial gate 402. Once sacrificial gate 402 is removed, sacrificial layers 202 may also be removed using a selective isotropic etching process that removes the material of sacrificial layers 202 but does not remove (or removes very little of) semiconductor layers 204 or any other exposed layers (e.g., inner gate spacers). At this point, the suspended (sometimes called released) semiconductor layers 204 form nanoribbons 602a/602b/602c that extend in the first direction (into and out of the page) between corresponding source or drain regions 502a/502b/502c.

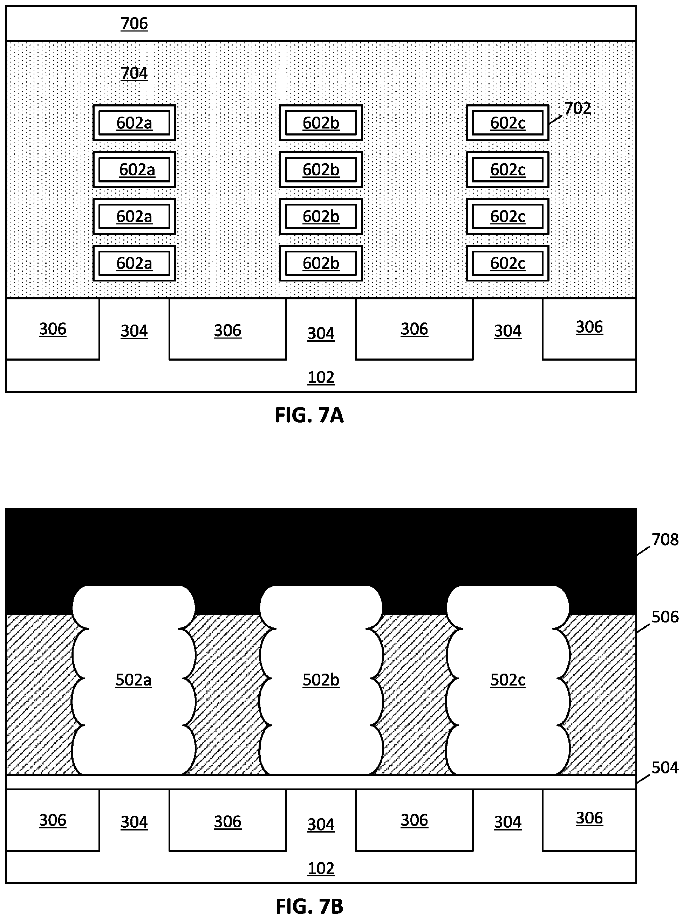

Figures 7A and 7B depict the cross-section views of the structure shown in Figures 6A and 6B, respectively, following the formation of a gate structure around nanoribbons 602a/602b/602c within the gate trench, according to some embodiments. As noted above, the gate structure includes a gate dielectric 702 and a gate electrode 704. Gate dielectric 702 may be conformally deposited around nanoribbons 602a/602b/602c using any suitable deposition process, such as atomic layer deposition (ALD). Gate dielectric 702 may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 702 is hafnium oxide with a thickness between about 1 nm and about 5 nm. In some embodiments, gate dielectric 702 may include one or more silicates (e.g., titanium silicate, tungsten silicate, niobium silicate, and silicates of other transition metals). Gate dielectric 702 may be a multilayer structure, in some examples. For instance, gate dielectric 702 may include a first layer on nanoribbons 602a/602b/602c, and a second layer on the first layer. The first layer can be, for instance, an oxide of the semiconductor layers (e.g., silicon dioxide) and the second layer can be a high-k dielectric material (e.g., hafnium oxide). In some embodiments, an annealing process may be carried out on gate dielectric 702 to improve its quality when a high-k dielectric material is used. In some embodiments, the high-k material can be nitridized to improve its aging resistance.

Gate electrode 704 may be deposited over gate dielectric 702 and can be any conductive structure. In some embodiments, gate electrode 704 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 704 may include, for instance, one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

According to some embodiments, a gate cap 706 may be formed by first recessing gate electrode 704 and filling the recess with a dielectric material. The dielectric material may then be polished such that its top surface is substantially coplanar with any adjacent spacer structures or material within the source/drain trench. Gate cap 706 may be any suitable dielectric material, such as silicon nitride.

According to some embodiments, a portion of dielectric fill 506 may be recessed within the source/drain trench to expose at least a top surface of source or drain regions 502a/502b/502c. A conductive contact 708 may be formed within the recess to contact at least the top surfaces of source or drain regions 502a/502b/502c. In some embodiments, dielectric fill 506 is recessed far enough to expose one or more side surfaces of source or drain regions 502a/502b/502c, in which case conductive contact 708 also contacts the exposed side surfaces of source or drain regions 502a/502b/502c. Conductive contact 708 may include any suitable conductive material, such as tungsten, cobalt, molybdenum, or ruthenium, for making electrical contact with the underlying source or drain regions 502a/502b/502c. A top surface of conductive contact 708 may be polished to be substantially coplanar with a top surface of gate cap 706. It should be understood that conductive contact 708 may include any number of conductive layers, such as a silicide layer or other similar resistance-reducing layer to provide a better Ohmic contact with the source or drain regions.

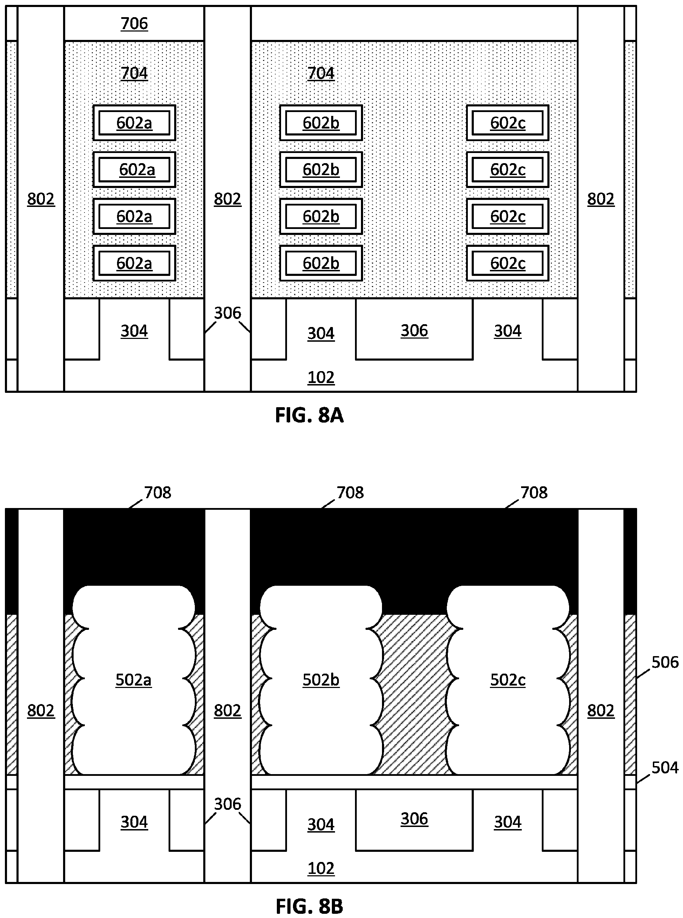

Figures 8A and 8B depict cross-section views of the structure shown in Figures 7A and 7B, respectively, following the formation of dielectric walls 802 extending in the first direction between some adjacent devices, according to some embodiments. Dielectric walls 802 extend to a depth at least through an entire thickness of the gate structures to isolate separate gate structures along the second direction. In some embodiments, dielectric walls 802 extend into at least a portion of dielectric fill 306 or through an entire thickness of dielectric fill 306. In some embodiments, dielectric walls 802 extend entirely through dielectric fill 306 and into a portion of substrate 102.

According to some embodiments, dielectric walls 802 may be formed by first forming corresponding gate cut recesses through gate cap 706, contact 708 and gate electrode 704 using any suitable metal gate etch process that iteratively etches through portions of gate electrode 704 while simultaneously protecting the sidewalls of the recess from lateral etching to provide a high height-to-width aspect ratio recess (e.g., aspect ratio of 5:1 or higher, or 10:1 or higher). The gate cut recesses may extend in the first direction through multiple gate trenches and source/drain trenches to isolate adjacent gate structures and source or drain regions. The gate cut recesses may be filled with one or more dielectric materials to form dielectric walls 802. For example, dielectric walls 802 may include only silicon dioxide or silicon nitride or silicon carbide. In some examples, dielectric walls 802 include a first dielectric layer deposited first and a second dielectric layer or dielectric fill formed on the first dielectric layer. The first dielectric layer may include a high-k dielectric material (e.g., materials with a dielectric constant higher than that of silicon dioxide or higher than 3.9) while the second dielectric layer may include a low-k dielectric material (e.g. materials with a dielectric constant lower than that of silicon dioxide, such as porous silicon dioxide, or lower than 3.9). In the illustrated example, a given dielectric wall 802 extends between nanoribbons 602a and nanoribbons 602b and also extends between source or drain region 502a and source or drain region 502b. In some examples where devices are closely packed, dielectric walls 802 may contact one or more sidewalls of source or drain regions 502a/502b/502c.

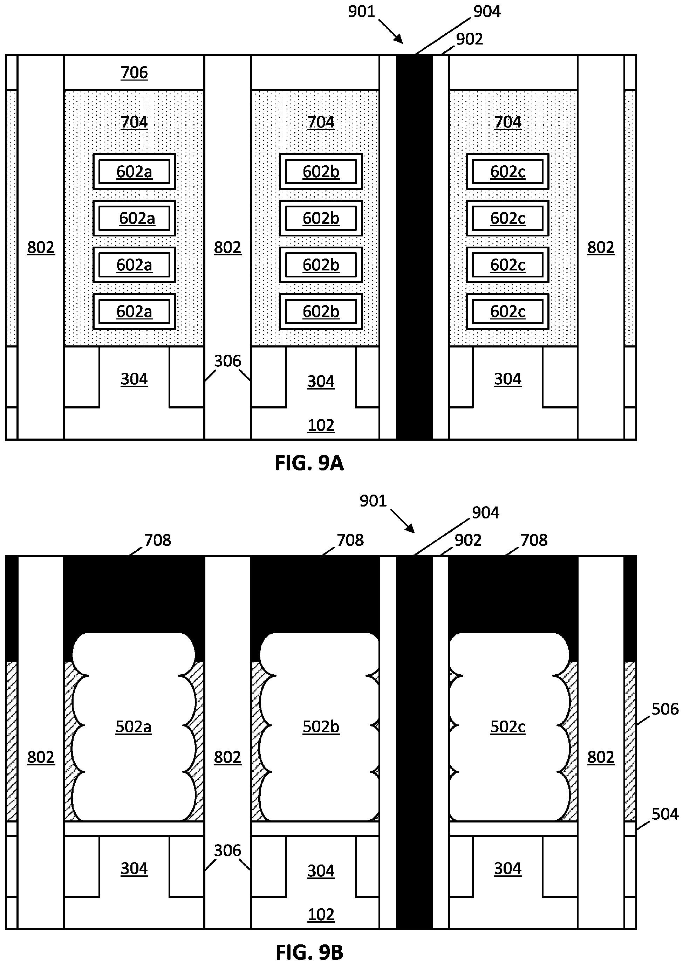

Figures 9A and 9B depict the cross-section views of the structure shown in Figures 8A and 8B, respectively, following the formation of a via structure 901, according to some embodiments. Via structure 901 may extend to a depth at least through an entire thickness of the gate structures. In some embodiments, via structure 901 extends through an entire thickness of dielectric fill 306.

Similar to the formation of dielectric walls 802, via structure 901 may be formed by first forming a corresponding via recess through gate cap 706, contact 708 and gate electrode 704 using any suitable metal gate etch process that iteratively etches through portions of gate electrode 704 while simultaneously protecting the sidewalls of the recess from lateral etching. In some embodiments, a widest dimension of the via recess (e.g., at a top of the via recess) along the second direction is between about 20 nm and about 30 nm, such that the resulting via structure 901 has a widest dimension between about 20 nm and about 30 nm. The via recess may be generally wider along the second direction compared to the recesses used to form dielectric walls 802, and as such may have a lower aspect ratio. In some examples, the via recess has an aspect ratio of around 4:1 up to around 8:1.

Once the via recess has been formed, a dielectric liner 902 is formed along at least the sidewalls of the recess (and may also form on the bottom of the recess), according to some embodiments. Dielectric liner 902 may be conformally deposited using suitable deposition techniques, such as ALD, CVD, or PECVD. Dielectric liner 902 may be any suitable dielectric material. In some examples, dielectric liner 902 includes a dielectric material such as silicon nitride, tin nitride, or tin oxide, or a low-k dielectric (e.g., porous silicon dioxide), to name a few examples. Dielectric liner 902 may be deposited to a final thickness within the via recess between about 2 nm and about 5 nm. Dielectric liner 902 may represent any number of deposited dielectric layers. In some examples, a first dielectric liner layer directly on gate electrode 704 includes a high-k dielectric material and a second dielectric liner layer on the first dielectric liner layer includes a low-k dielectric material.

According to some embodiments, a conductive via 904 is formed within a remaining volume of the via recess and on dielectric liner 902. Conductive via 904 may include any suitable conductive material such as tungsten, molybdenum, ruthenium, cobalt, or any alloys thereof. As noted above, conductive via 904 extends at least below a bottom surface of the gate structure, and may also extend below a bottom surface of dielectric fill 306. According to some embodiments, conductive via 904 acts as a power or signal line between topside interconnects and backside interconnects on the die.

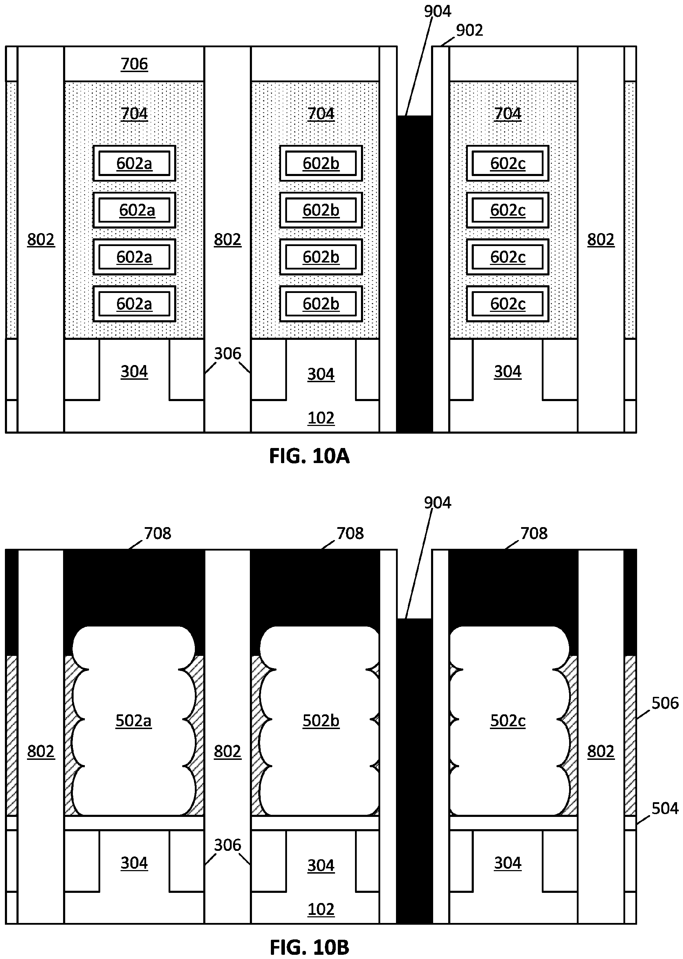

Figures 10A and 10B depict the cross-section views of the structure shown in Figures 9A and 9B, respectively, following the recessing of conductive via 904 between dielectric liner 902, according to some embodiments. Conductive via 904 may be recessed using any suitable metal etch process while protecting other metal elements (such as contacts 708) with a hard mask layer or a photoresist layer. According to some embodiments, conductive via 904 is recessed such that its top surface is below a top surface of contacts 708 and/or below a top surface of gate electrode 704. In some examples, the top surface of conductive via 904 is below the top surface of the adjacent source or drain regions 502/502c.

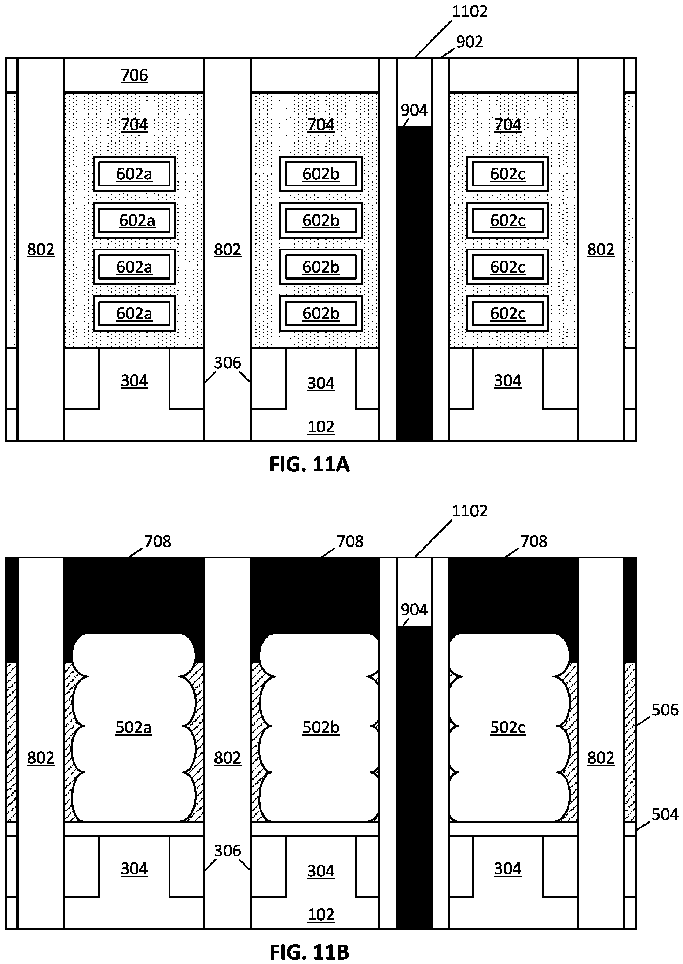

Figures 11A and 11B depict the cross-section views of the structure shown in Figures 10A and 10B, respectively, following the formation of a dielectric plug 1102 on the top surface of conductive via 904, according to some embodiments. Dielectric plug 1102 may be any suitable dielectric material, such as silicon dioxide, silicon nitride, silicon oxycarbide, or silicon oxycarbonitride. In some examples, dielectric plug 1102 is the same dielectric material as dielectric liner 902. Dielectric plug 1102 may substantially fill the cavity left behind following the recessing of conductive via 904. A top surface of dielectric plug 1102 may be polished to be substantially coplanar with a top surface of dielectric cap layer 706.

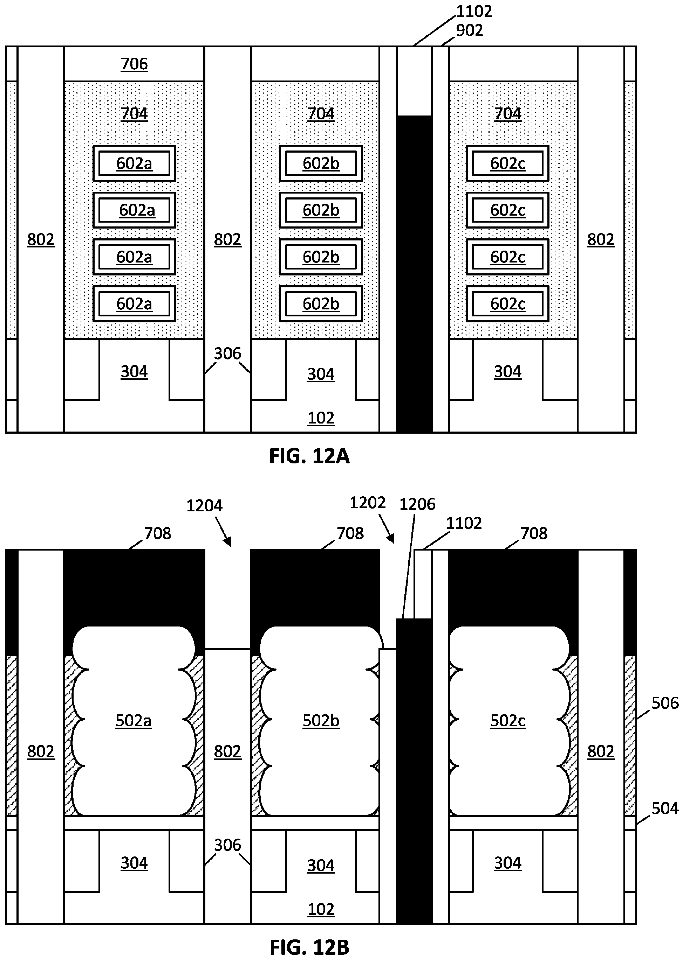

Figures 12A and 12B depict the cross-section views of the structure shown in Figures 11A and 11B, respectively, following the formation of a first recess 1202 between conductive via 904 and an adjacent contact 708 and a second recess 1204 between two adjacent contacts, according to some embodiments. First recess 1202 may be formed through a portion of dielectric liner 902 and a portion of dielectric plug 1102 to expose at least a portion of a top surface 1206 of conductive via 904. In some embodiments, a top portion of dielectric liner 902 is completely removed such that at least a portion of a sidewall of the adjacent contact 708 is exposed, and a portion of a sidewall of the conductive via 904 may also be exposed. In some such cases, a portion of dielectric plug 1102 remains (as shown), and in other cases dielectric plug 1102 is completely or mostly removed as well. The portion of dielectric liner 902 and plug 1102 adjacent to the gate electrode 704 remain intact (e.g., by way of a patterned mask layer). Any suitable anisotropic dielectric etching process may be used to remove portions of both dielectric liner 902 and dielectric plug 1102. In some examples, the removal of the portion of dielectric liner 902 exposes at least a portion of the adjacent source or drain region 502b. In this example, a portion of the dielectric liner 902 that is adj acent to the gate electrode 704 (as shown in Figure 12A) has a top surface that is higher (e.g., higher by 2 to 4 nanometers, or higher) than the top surface of the portion of the liner 902 that is adjacent to the source or drain region 502b (as shown in Figure 12B). As further shown in the example of Figure 12B, a portion of the dielectric liner 902 that is adjacent to the source or drain region 502b has a top surface that is lower (e.g., lower by 1 to 2 nanometers, or lower) than the top surface 1206 of the conductive via 904. Such a structure allows the subsequently provisioned conductive bridge to robustly contact both the contact 708 and via 904.

According to some embodiments, second recess 1204 may be formed between adjacent contacts. In the illustrated example, second recess 1204 is formed by removing a portion of dielectric wall 802 between adjacent contacts 708 over source or drain region 502a and source or drain region 502b. The same masking layer or masking material may be used to expose the various dielectric materials along the source/drain trench, such that first recess 1202 and second recess 1204 are formed at the same time using the same etching process. Note that only dielectric materials within the source/drain trench are exposed while masking layers protect the topside dielectric materials within the gate trench. Second recess 1204 may have a similar depth as first recess 1202. According to some embodiments, any number of dielectric walls 802 can have their top portion removed to form recesses between any number of adjacent contacts along a given source/drain trench.

Figures 13A and 13B depict the cross-section views of the structure shown in Figures 12A and 12B, respectively, following the formation of a conductive bridge 1302 within first recess 1202 and a conductive plug 1304 within second recess 1204, according to some embodiments. Conductive bridge 1302 extends between and contacts both conductive via 904 and adjacent contact 708. According to some embodiments, conductive bridge 1302 contacts at least a portion of the top surface of conducive via 904 and a least a portion of the sidewall of contact 708. Conductive bridge 1302 may also extend below the top surface of conducive via 904 along one side of conducive via 904. According to some embodiments, conductive plug 1304 extends between adjacent contacts 708 along the second direction. Each of conductive bridge 1302 and conductive plug 1304 may include any suitable conductive material, such as tungsten, molybdenum, or other metals. In some examples, conductive bridge 1302 and conductive plug 1304 includes the same conductive material as contacts 708 and/or conductive via 904. According to some embodiments, conductive bridge 1302 and conductive plug 1304 are formed together during the same metal deposition process such that they include the same conductive material.

Contacts 708 over source or drain regions 502a and 502b, conductive bridge 1302, and conductive plug 1304 may collectively form a single conductive contact within the device layer that contacts multiple source or drain regions. For example, additional adjacent source or drain regions along the same source/drain trench may also be contacted by forming additional conductive plugs across adjacent dielectric walls 802. In some embodiments, there may not be any noticeable seams or boundaries between any of contacts 708, conductive bridge 1302, and conductive plug 1304 depending on the materials used. When different materials or deposition processes are used, seams or boundaries may be noticeable between different conductive elements. In still other embodiments, contacts 708 and conductive bridge 1302 are formed at the same time, such as the example case where the processing of Figure 7B is carried out after the process of Figure 12B but before the process of Figure 13B, thus allowing the same deposition process to be used when forming contacts 708 and conductive bridge 1302. In some such cases, a monolithic conductive feature that includes both conductive contact 708 and conductive bridge 1302 (which collectively may be more simply referred to as a contact) extends in the second direction to contact at least a portion of the top surface and/or side surface of the conductive via 904. In some such cases, the contacted portion of the side surface of via 904 is about 2 to 4 nanometers in length, or more. Again, such structure or multi-surface topology allows for robust conductive contact to via 904.

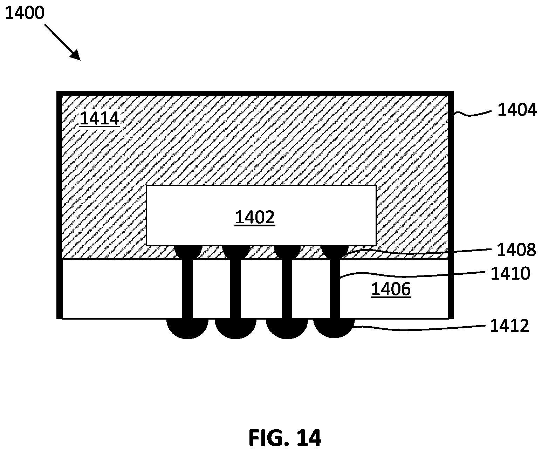

Figure 14 illustrates an example embodiment of a chip package 1400, in accordance with an embodiment of the present disclosure. As can be seen, chip package 1400 includes one or more dies 1402. One or more dies 1402 may include at least one integrated circuit having semiconductor devices, such as any of the semiconductor devices disclosed herein. One or more dies 1402 may include any other circuitry used to interface with other devices formed on the dies, or other devices connected to chip package 1400, in some example configurations.

As can be further seen, chip package 1400 includes a housing 1404 that is bonded to a package substrate 1406. The housing 1404 may be any housing, and may provide, for example, electromagnetic shielding and environmental protection for the components of chip package 1400. The one or more dies 1402 may be conductively coupled to a package substrate 1406 using connections 1408, which may be implemented with any number of connection mechanisms, such as solder bumps, ball grid array (BGA), pins, or wire bonds, to name a few examples. Package substrate 1406 may be any package substrate, but in some cases includes a dielectric material having conductive pathways (e.g., including conductive vias and lines) extending through the dielectric material between the faces of package substrate 1406, or between different locations on each face. In some embodiments, package substrate 1406 may have a thickness less than 1 millimeter (e.g., between 0.1 millimeters and 0.5 millimeters), although any number of package geometries can be used. Additional conductive contacts 1412 may be disposed at an opposite face of package substrate 1406 for conductively contacting, for instance, a printed circuit board (PCB). One or more vias 1410 extend through a thickness of package substrate 1406 to provide conductive pathways between one or more of connections 1408 to one or more of contacts 1412. Vias 1410 are illustrated as single straight columns through package substrate 1406 for ease of illustration, although other configurations can be used (e.g., damascene, dual damascene, through-silicon via, or an interconnect structure that meanders through the thickness of substrate 1406 to contact one or more intermediate locations therein). In still other embodiments, vias 1410 are fabricated by multiple smaller stacked vias, or are staggered at different locations across package substrate 1406. In the illustrated embodiment, contacts 1412 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1412, to inhibit shorting.

In some embodiments, a mold material 1414 may be disposed around the one or more dies 1402 included within housing 1404 (e.g., between dies 1402 and package substrate 1406 as an underfill material, as well as between dies 1402 and housing 1404 as an overfill material). Although the dimensions and qualities of the mold material 1414 can vary from one embodiment to the next, in some embodiments, a thickness of mold material 1414 is less than 1 millimeter. Example materials that may be used for mold material 1414 include epoxy mold materials, as suitable. In some cases, the mold material 1414 is thermally conductive, in addition to being electrically insulating.

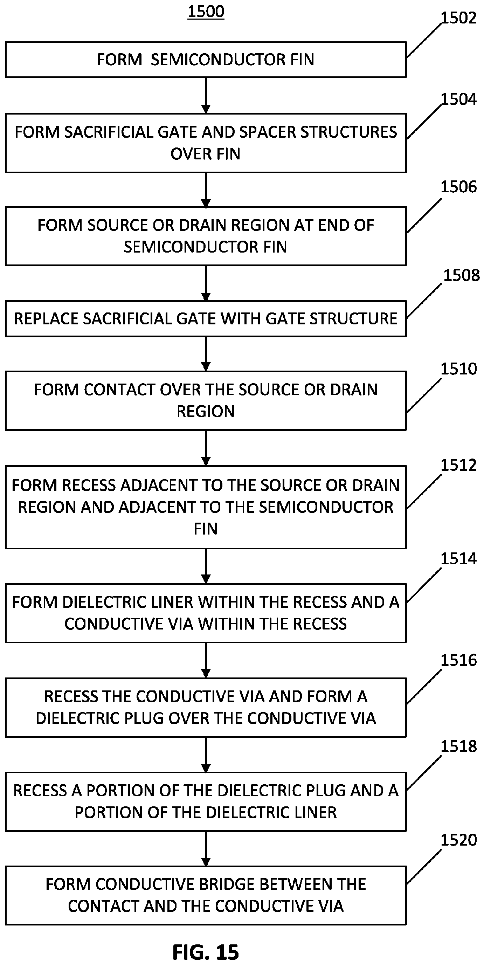

Figure 15 is a flow chart of a method 1500 for forming at least a portion of an integrated circuit, according to an embodiment. Various operations of method 1500 may be illustrated in Figures 2A - 13A and Figures 2B - 13B. However, the correlation of the various operations of method 1500 to the specific components illustrated in the aforementioned figures is not intended to imply any structural and/or use limitations. Rather, the aforementioned figures provide one example embodiment of method 1500. Other operations may be performed before, during, or after any of the operations of method 1500. For example, method 1500 does not explicitly describe all processes that are performed to form common transistor structures. Some of the operations of method 1500 may be performed in a different order than the illustrated order.

Method 1500 begins with operation 1502 where any number of parallel semiconductor fins are formed, according to some embodiments. The semiconductor material in a given fin may be formed from a substrate such that the fin is an integral part of the substrate (e.g., etched from a bulk silicon substrate). Alternatively, the fin can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, the fin includes alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. The alternating layers can be blanket deposited and then etched into fins, or deposited into fin-shaped trenches. The fin may also include a cap structure over it that is used to define the location of the fin during, for example, an RIE process. The cap structure may be a dielectric material, such as silicon nitride.

According to some embodiments, a dielectric layer is formed around a subfin portion of the fin. In some embodiments, the dielectric layer extends between each pair of adjacent parallel fins and runs lengthwise in the same direction as the fins. In some embodiments, the anisotropic etching process that forms the fin also etches into a portion of the substrate and the dielectric layer may be formed within the recessed portions of the substrate. Accordingly, the dielectric layer acts as shallow trench isolation (STI) between adjacent fins. The dielectric layer may be any suitable dielectric material, such as silicon dioxide.

Method 1500 continues with operation 1504 where a sacrificial gate and spacer structures are formed over the fin. The sacrificial gate may be patterned using a gate masking layer in a strip that runs orthogonally over the fin (many gate masking layers and corresponding sacrificial gates may be formed parallel to one another (e.g., forming a cross-hatch pattern with any number of parallel fins). The gate masking layer may be any suitable hard mask material, such as CHM or silicon nitride. The sacrificial gate may be formed from any suitable material that can be selectively removed at a later time without damaging the semiconductor material of the fin. In one example, the sacrificial gate includes polysilicon. The spacer structures may be deposited and then etched back such that the spacer structures remain mostly only on sidewalls of any exposed structures. According to some embodiments, the spacer structures may be any suitable dielectric material, such as silicon nitride or silicon oxynitride.

Method 1500 continues with operation 1506 where source or drain regions are formed at the ends of the semiconductor regions of the fin. Any portions of the fin not protected by the sacrificial gate and spacer structures may be removed using, for example, an anisotropic etching process followed by the epitaxial growth of the source or drain regions from the exposed ends of the semiconductor layers in the fin. In some example embodiments, the source or drain regions are NMOS source or drain regions (e.g., epitaxial silicon) or PMOS source or drain regions (e.g., epitaxial SiGe).

According to some embodiments, a dielectric fill is formed over the source or drain regions. The dielectric fill may be formed adjacent to the various source or drain regions for additional electrical isolation between adjacent regions. The dielectric fill may also extend over a top surface of the source or drain regions. The dielectric fill can take up any remaining space along the source/drain trench, according to some embodiments. The dielectric fill may include any suitable dielectric material, such as silicon dioxide or silicon oxynitride.

Method 1500 continues with operation 1508 where the sacrificial gate is replaced with a gate structure. According to some embodiments, the sacrificial gate may be removed along with any sacrificial layers within the exposed fin between the spacer structures (in the case of GAA structures). A gate structure may then be formed in place of the sacrificial gate. The gate structure may include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any conductive material, such as a metal, metal alloy, or polysilicon. The gate electrode may be deposited using electroplating, electroless plating, CVD, ALD, PECVD, or PVD, to name a few examples.

Method 1500 continues with operation 1510 where a contact is formed over one of the source or drain regions. In some embodiments, the contact may include any suitable conductive material, such as tungsten, molybdenum, ruthenium, or cobalt. The contact may represent any number of different conductive materials that may be deposited to form a conductive connection to the underlying source or drain region.

Method 1500 continues with operation 1512 wherein a deep recess is formed adjacent to the source or drain region and also adjacent to the semiconductor regions in the gate trench. Accordingly, the recess may be a trench that runs along the first direction through any number of gate trenches and source/drain trenches. The recess may also be deep enough to pass through an entire thickness of the gate structure and an entire thickness of the dielectric layer beneath the gate structure. A reactive ion etching (RIE) process may be used to cut through the various material layers and form the trench-shaped recess.

Method 1500 continues with operation 1514 where a dielectric liner is formed within the recess followed by the formation of a conductive via within the recess. The dielectric liner may be conformally deposited using any suitable technique such as CVD or ALD to cover at least the sidewalls of the recess. The dielectric liner may include a dielectric material such as silicon nitride, tin nitride, tin oxide, or a low-k dielectric (porous version of any of these, or other dielectric material) to name a few examples. The dielectric liner may be deposited to a final thickness within the via recesses between about 2 nm and about 5 nm. The dielectric liner may represent any number of deposited dielectric layers.

According to some embodiments, the conductive via is formed within a remaining volume of the via recess and on the dielectric liner. Some voids may be present within the conductive via. The conductive via may include any suitable conductive material such as tungsten, molybdenum, ruthenium, cobalt, or any alloys thereof.

Method 1500 continues with operation 1516 where the conductive via is recessed such that a top surface of the conductive via is lowered below the top surface of the adjacent contact. In some examples, the top surface of the conductive via is lowered below the top surface of the adjacent source or drain region. Any suitable metal etching process may be used to remove a top portion of the conductive via. The recessing of the conductive via leaves a cavity between the dielectric liner where the portion of the conductive via was removed. This cavity may be filled or substantially filled (e.g., including voids) with a dielectric plug. The dielectric plug may be any suitable dielectric material, such as silicon dioxide, silicon nitride, silicon oxycarbide, or silicon oxycarbonitride. In some examples, the dielectric plug is the same dielectric material as the dielectric liner. A top surface of the dielectric plug may be polished to be substantially coplanar with a top surface of the dielectric liner.

Method 1500 continues with operation 1518 where at least a portion of both the dielectric liner and the dielectric plug are recessed to expose at least a portion of the top surface of the conductive via. An anisotropic etching process may be used to form the recess through the dielectric materials of the dielectric liner and the dielectric plug. According to some embodiments, the recess has a depth that exposes a portion of the top surface and a portion of one of the sidewalls of the conductive via. Due to the removal of a top portion of the dielectric liner, the recess also exposes a sidewall portion of the contact, according to some embodiments. In this manner, a portion of the dielectric liner that is adjacent to the source or drain region may have a top surface that is lower (e.g., lower by 1 to 2 nanometers, or lower) than the top surface of the conductive via, and a portion of the liner that is adjacent to the gate electrode has a top surface that is higher (e.g., higher by 2 to 4 nanometers, or higher) than the top surface of the portion of the liner that is adjacent to the source or drain region. As described above, such topology allows the conductive bridge formed at 1520 to robustly contact both the contact 708 and via 904.

Method 1500 continues with operation 1520 wherein a conductive bridge is formed within the recess. The conductive bridge may be tungsten or any other suitable metal, such as ruthenium, cobalt, molybdenum, or any alloys thereof. According to some embodiments, a top surface of the conductive bridge is polished using, for example, CMP until it is substantially coplanar with a top surface of the contact in the source/drain trench. According to some embodiments, the conductive bridge contacts at least a portion of the top surface of the conducive via and a least a portion of the sidewall of the contact. The conductive bridge may also extend below the top surface of the conducive via along one side of the conducive via. The conductive bridge acts like an interconnect between the contact and the conductive via but is formed within the device layer beneath the interconnect region, thus freeing up more space in the interconnect region for other metal layers.

### Example System

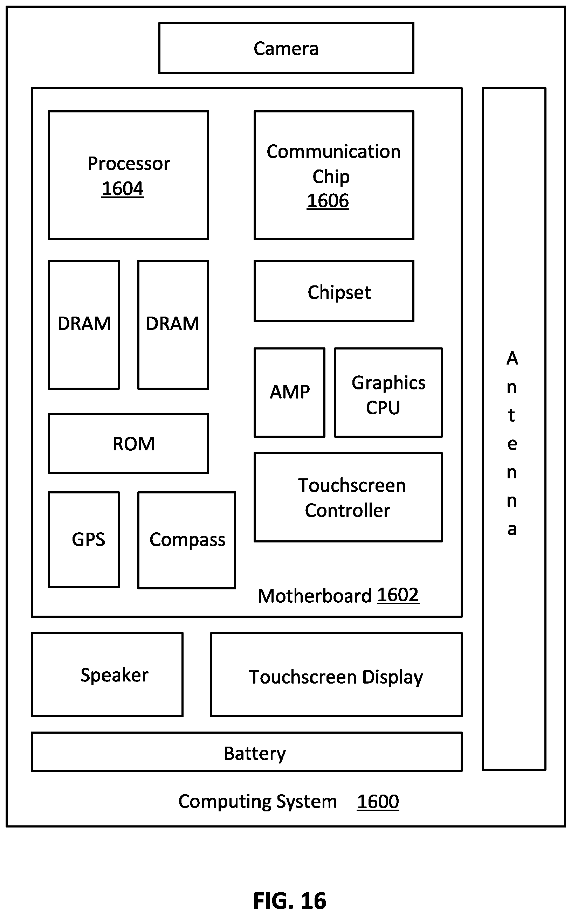

FIG. 16 is an example computing system implemented with one or more of the integrated circuit structures as disclosed herein, in accordance with some embodiments of the present disclosure. As can be seen, the computing system 1600 houses a motherboard 1602. The motherboard 1602 may include a number of components, including, but not limited to, a processor 1604 and at least one communication chip 1606, each of which can be physically and electrically coupled to the motherboard 1602, or otherwise integrated therein. As will be appreciated, the motherboard 1602 may be, for example, any printed circuit board (PCB), whether a main board, a daughterboard mounted on a main board, or the only board of system 1600, etc.

Depending on its applications, computing system 1600 may include one or more other components that may or may not be physically and electrically coupled to the motherboard 1602. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1600 may include one or more integrated circuit structures or devices configured in accordance with an example embodiment (e.g., a module including an integrated circuit on a substrate, the substrate having semiconductor devices that include a recessed via connected to an adjacent source or drain contact). In some embodiments, multiple functions can be integrated into one or more chips (e.g., for instance, note that the communication chip 1606 can be part of or otherwise integrated into the processor 1604).

The communication chip 1606 enables wireless communications for the transfer of data to and from the computing system 1600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1606 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1600 may include a plurality of communication chips 1606. For instance, a first communication chip 1606 may be dedicated to shorter range wireless communications such as Wi-Fi and Bluetooth and a second communication chip 1606 may be dedicated to longer range wireless communications such as GPS, EDGE, GPRS, CDMA, WiMAX, LTE, Ev-DO, and others.

The processor 1604 of the computing system 1600 includes an integrated circuit die packaged within the processor 1604. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1606 also may include an integrated circuit die packaged within the communication chip 1606. In accordance with some such example embodiments, the integrated circuit die of the communication chip includes one or more semiconductor devices as variously described herein. As will be appreciated in light of this disclosure, note that multistandard wireless capability may be integrated directly into the processor 1604 (e.g., where functionality of any chips 1606 is integrated into processor 1604, rather than having separate communication chips). Further note that processor 1604 may be a chip set having such wireless capability. In short, any number of processor 1604 and/or communication chips 1606 can be used. Likewise, any one chip or chip set can have multiple functions integrated therein.

In various implementations, the computing system 1600 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1600 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a semiconductor region extending in a first direction from a source or drain region, a gate electrode extending in a second direction different from the first direction and over the semiconductor region, a contact on a top surface of the source or drain region, a conductive via extending in the first direction adjacent to the semiconductor region, extending in the first direction adjacent to the source or drain region, and extending in a third direction through a portion of the gate electrode, and a conductive bridge between the contact and the conductive via. A top surface of the conductive via is below a top surface of the contact. The conductive bridge extends from a sidewall of the contact and is on at least a portion of the top surface of the conductive via.

Example 2 includes the integrated circuit of Example 1, further comprising a liner extending in the first direction, such that the liner is between the conductive via and the gate electrode and also between the source or drain region and the conductive via. A portion of the liner that is adjacent to the source or drain region has a top surface that is at least 2 nanometers lower than the top surface of the conductive via.

Example 3 includes the integrated circuit of Example 2, wherein a portion of the liner that is adjacent to the gate electrode has a top surface that is at least 4 nanometers higher than the top surface of the portion of the liner that is adjacent to the source or drain region.

Example 4 includes the integrated circuit of Example 2 or 3, wherein the conductive via plus the liner has a greatest width along the second direction between about 20 nm and about 30 nm.

Example 5 includes the integrated circuit of any one of Examples 1-4, wherein the semiconductor region comprises a plurality of semiconductor nanoribbons.

Example 6 includes the integrated circuit of Example 5, wherein the plurality of semiconductor nanoribbons comprise germanium, silicon, or a combination thereof.

Example 7 includes the integrated circuit of any one of Examples 1-6, wherein the conductive via comprises tungsten, cobalt, molybdenum, or ruthenium.

Example 8 includes the integrated circuit of any one of Examples 1-7, wherein the conductive bridge comprises tungsten, cobalt, molybdenum, or ruthenium.

Example 9 includes the integrated circuit of any one of Examples 1-8, wherein the conductive bridge and the conductive via comprise the same conductive material.

Example 10 includes the integrated circuit of any one of Examples 1-9, further comprising a dielectric cap over the top surface of the conductive via, wherein a top surface of the dielectric cap is substantially coplanar with a top surface of the contact.

Example 11 includes the integrated circuit of any one of Examples 1-10, wherein the top surface of the conductive via is below a top surface of the source or drain region.

Example 12 includes the integrated circuit of any one of Examples 1-11, wherein a top surface of the conductive bridge is substantially coplanar with a top surface of the contact.

Example 13 includes the integrated circuit of any one of Examples 1-12, wherein the source or drain region is a first source or drain region, the contact is a first contact, and the conductive bridge is a first conductive bridge and the integrated circuit further includes a second source or drain region adjacent to the first source or drain region along the second direction, a dielectric wall extending in the first direction between the first source or drain region and the second source or drain region, a second contact on a top surface of the second source or drain region, and a second conductive bridge connected between the first contact and the second contact and over the dielectric wall. A top surface of the second conductive bridge is substantially coplanar with a top surface of the first contact and a top surface of the second contact.

Example 14 includes the integrated circuit of any one of Examples 1-13, wherein the first direction is orthogonal to the second direction, and the third direction is orthogonal to the first and second directions.

Example 15 includes the integrated circuit of any one of Examples 1-14, further comprising a dielectric layer beneath the gate electrode, wherein the conductive via extends in the third direction through an entire thickness of the dielectric layer.

Example 16 is a printed circuit board comprising the integrated circuit of any one of Examples 1-15.

Example 17 is an electronic device including a chip package having one or more dies. At least one of the one or more dies includes a semiconductor region extending in a first direction from a source or drain region, a gate electrode extending in a second direction different from the first direction and over the semiconductor region, a dielectric layer beneath the gate electrode, a contact on a top surface of the source or drain region, a conductive via extending in the first direction adjacent to the semiconductor region, extending in the first direction adjacent to the source or drain region, and extending in a third direction through a portion of the gate electrode and through an entire thickness of the dielectric layer, and a conductive bridge between the contact and the conductive via. A top surface of the conductive via is below a top surface of the contact. The conductive bridge abuts a portion of the contact and is on at least a portion of the top surface of the conductive via.

Example 18 includes the electronic device of Example 17, wherein the at least one of the one or more dies further comprises a liner between the conductive via and the gate electrode.

Example 19 includes the electronic device of Example 18, wherein the liner comprises a low-k dielectric material.

Example 20 includes the electronic device of Example 18 or 19, wherein the conductive via plus the liner has a greatest width along the second direction between about 20 nm and about 30 nm.

Example 21 includes the electronic device of any one of Examples 17-20, wherein the semiconductor region comprises a plurality of semiconductor nanoribbons.

Example 22 includes the electronic device of Example 21, wherein the plurality of semiconductor nanoribbons comprise germanium, silicon, or a combination thereof.

Example 23 includes the electronic device of any one of Examples 17-22, wherein the conductive via comprises tungsten, cobalt, molybdenum, or ruthenium.

Example 24 includes the electronic device of any one of Examples 17-23, wherein the conductive bridge comprises tungsten, cobalt, molybdenum, or ruthenium.

Example 25 includes the electronic device of any one of Examples 17-24, wherein the conductive bridge and the conductive via comprise the same conductive material.

Example 26 includes the electronic device of any one of Examples 17-25, wherein the at least one of the one or more dies further comprises a dielectric cap over the top surface of the conductive via. A top surface of the dielectric cap is substantially coplanar with a top surface of the contact.

Example 27 includes the electronic device of any one of Examples 17-26, wherein the top surface of the conductive via is below a top surface of the source or drain region.

Example 28 includes the electronic device of any one of Examples 17-27, wherein a top surface of the conductive bridge is substantially coplanar with a top surface of the contact.

Example 29 includes the electronic device of any one of Examples 17-28, wherein the source or drain region is a first source or drain region, the contact is a first contact, and the conductive bridge is a first conductive bridge. The at least one of the one or more dies further includes a second source or drain region adjacent to the first source or drain region along the second direction, a dielectric wall extending in the first direction between the first source or drain region and the second source or drain region, a second contact on a top surface of the second source or drain region, and a second conductive bridge connected between the first contact and the second contact and over the dielectric wall. A top surface of the second conductive bridge is substantially coplanar with a top surface of the first contact and a top surface of the second contact.

Example 30 includes the electronic device of any one of Examples 17-29, wherein the first direction is orthogonal to the second direction, and the third direction is orthogonal to the first and second directions.

Example 31 includes the electronic device of any one of Examples 17-30, further comprising a printed circuit board, wherein the chip package is coupled to the printed circuit board.

Example 32 is a method of forming an integrated circuit. The method includes forming a fin comprising semiconductor material, the fin extending above a substrate and extending in a first direction; forming a gate electrode extending over the fin in a second direction different from the first direction; forming a source or drain region at an end of the fin; forming a contact over the source or drain region; forming a recess through the gate electrode adjacent to the fin, the recess extending in the first direction through the gate electrode and adjacent to the source or drain region; forming a dielectric material within the recess; forming a conductive via within the recess, the conductive via extending in the first direction, such that the dielectric material is between the conductive via and the gate electrode and the dielectric material is between the conductive via and the contact; recessing the conductive via such that a top surface of the conductive via is below a top surface of the contact; forming a dielectric cap over the top surface of the recessed conductive via; recessing a portion of the dielectric material between the dielectric cap and the contact and recessing at least a portion of the dielectric cap, such that at least a portion of the top surface of the conductive via is exposed; and forming a conductive bridge over the at least a portion of the top surface of the conductive via, the conductive bridge abutting the contact.

Example 33 includes the method of Example 32, further comprising forming a gate dielectric layer around the semiconductor material before forming the gate electrode.

Example 34 includes the method of Example 32 or 33, wherein forming the dielectric material comprises forming a dielectric liner along sidewalls of the recess.

Example 35 includes the method of Example 34, wherein forming the conductive via comprises forming a conductive material within a remaining volume of the recess on the dielectric liner.

Example 36 includes the method of any one of Examples 32-35, wherein forming the dielectric material comprises filling a volume within the recess with the dielectric material.

Example 37 includes the method of Example 36, wherein forming the conductive via comprises forming the conductive via through a thickness of the dielectric material within the recess.

Example 38 includes the method of any one of Examples 32-37, wherein recessing the conductive via comprises recessing the conductive via such that a top surface of the conductive via is below a top surface of the source or drain region.

Example 39 is an integrated circuit that includes a semiconductor region extending in a first direction from a source or drain region, a gate electrode extending in a second direction different from the first direction and over the semiconductor region, a dielectric layer beneath the gate electrode, a conductive via extending in the first direction adjacent to the semiconductor region, extending in the first direction adjacent to the source or drain region, and extending in a third direction through a portion of the gate electrode and through an entire thickness of the dielectric layer, and a conductive contact on a top surface of the source or drain region. A top surface of the conductive via is below a top surface of the gate electrode. The conductive contact extends in the second direction to contact at least a portion of the top surface of the conductive via.

Example 40 includes the integrated circuit of Example 39, further comprising a liner between the conductive via and the gate electrode.

Example 41 includes the integrated circuit of Example 40, wherein the liner comprises a low-k dielectric material.

Example 42 includes the integrated circuit of Example 40 or 41, wherein the conductive via plus the liner has a greatest width along the second direction between about 20 nm and about 30 nm.

Example 43 includes the integrated circuit of any one of Examples 39-42, wherein the semiconductor region comprises a plurality of semiconductor nanoribbons.

Example 44 includes the integrated circuit of Example 43, wherein the plurality of semiconductor nanoribbons comprise germanium, silicon, or a combination thereof.

Example 45 includes the integrated circuit of any one of Examples 39-44, wherein the conductive via comprises tungsten, cobalt, molybdenum, or ruthenium.

Example 46 includes the integrated circuit of any one of Examples 39-45, wherein the conductive contact comprises tungsten, cobalt, molybdenum, or ruthenium.

Example 47 includes the integrated circuit of any one of Examples 39-46, further comprising a dielectric cap over the top surface of the conductive via, wherein a top surface of the dielectric cap is substantially coplanar with a top surface of the contact.

Example 48 includes the integrated circuit of any one of Examples 39-47, wherein the top surface of the conductive via is below a top surface of the source or drain region.

Example 49 includes the integrated circuit of any one of Examples 39-48, wherein the conductive contact extends in the second direction to contact at least a portion of a side surface of the conductive via.

Example 50 includes the integrated circuit of any one of Examples 39-49, wherein the source or drain region is a first source or drain region and the integrated circuit further includes a second source or drain region adjacent to the first source or drain region along the second direction, and a dielectric wall extending in the first direction between the first source or drain region and the second source or drain region. The conductive contact further extends along the second direction over the dielectric wall an on at least a portion of a top surface of the second source or drain region.

Example 51 includes the integrated circuit of any one of Examples 39-50, wherein the first direction is orthogonal to the second direction, and the third direction is orthogonal to the first and second directions.

Example 52 is a printed circuit board comprising the integrated circuit of any one of Examples 39-51.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a semiconductor region extending in a first direction from a source or drain region;
a gate electrode extending in a second direction over the semiconductor region, the second direction being different than the first direction;
a contact on a top surface of the source or drain region;
a conductive via extending in the first direction adjacent to the semiconductor region, extending in the first direction adjacent to the source or drain region, and extending in a third direction through a portion of the gate electrode, wherein a top surface of the conductive via is below a top surface of the contact; and
a conductive bridge between the contact and the conductive via, wherein the conductive bridge extends from a sidewall of the contact and is on at least a portion of the top surface of the conductive via.

2. The integrated circuit of claim 1, further comprising a liner extending in the first direction, such that the liner is between the conductive via and the gate electrode and also between the source or drain region and the conductive via, wherein a portion of the liner that is adjacent to the source or drain region has a top surface that is at least 2 nanometers lower than the top surface of the conductive via.

3. The integrated circuit of claim 2, wherein a portion of the liner that is adjacent to the gate electrode has a top surface that is at least 4 nanometers higher than the top surface of the portion of the liner that is adjacent to the source or drain region.

4. The integrated circuit of claim 2 or 3, wherein the conductive via plus the liner has a greatest width along the second direction between about 20 nm and about 30 nm.

5. The integrated circuit of any one of claims 1 through 4, wherein the semiconductor region comprises a plurality of semiconductor nanoribbons.

6. The integrated circuit of claim 5, wherein the plurality of semiconductor nanoribbons comprise germanium, silicon, or a combination thereof.

7. The integrated circuit of any one of claims 1 through 6, wherein the conductive via comprises tungsten, cobalt, molybdenum, or ruthenium.

8. The integrated circuit of any one of claims 1 through 7, wherein the conductive bridge comprises tungsten, cobalt, molybdenum, or ruthenium.

9. The integrated circuit of any one of claims 1 through 8, wherein the conductive bridge and the conductive via comprise the same conductive material.

10. The integrated circuit of any one of claims 1 through 9, further comprising a dielectric cap over the top surface of the conductive via, wherein a top surface of the dielectric cap is substantially coplanar with a top surface of the contact.

11. The integrated circuit of any one of claims 1 through 10, wherein the top surface of the conductive via is below a top surface of the source or drain region.

12. The integrated circuit of any one of claims 1 through 11, wherein a top surface of the conductive bridge is substantially coplanar with a top surface of the contact.

13. The integrated circuit of any one of claims 1 through 12, wherein the source or drain region is a first source or drain region, the contact is a first contact, and the conductive bridge is a first conductive bridge and the integrated circuit further includes a second source or drain region adjacent to the first source or drain region along the second direction, a dielectric wall extending in the first direction between the first source or drain region and the second source or drain region, a second contact on a top surface of the second source or drain region, and a second conductive bridge connected between the first contact and the second contact and over the dielectric wall. A top surface of the second conductive bridge is substantially coplanar with a top surface of the first contact and a top surface of the second contact.

14. The integrated circuit of any one of claims 1 through 13, further comprising a dielectric layer beneath the gate electrode, wherein the conductive via extends in the third direction through an entire thickness of the dielectric layer.

15. A printed circuit board comprising the integrated circuit of any one of claims 1 through 14.
